# EUROPEAN PATENT APPLICATION

(11) **EP 4 553 883 A1**
(43) Date of publication of application: **14.05.2025**
(21) Application number: 22950062.4
(22) Date of filing: 10.11.2022
(51) Int. Cl.: H01J 1/04, H01J 1/06

(54) **ELECTRON EMISSION APPARATUS AND ELECTRONIC APPARATUS**

(30) Priority: 08.07.2022 CN 202210805414
(71) Applicant: Westlake University, Hangzhou, Zhejiang 310024 (CN)
(72) Inventor: LI, Xijun, Hangzhou, Zhejiang 310024 (CN)
(74) Representative: Petraz, Gilberto Luigi
(86) International application number: PCT/CN2022/131028
(87) International publication number: WO 2024/007504

(57) **Abstract**

Provided in the embodiments of the present disclosure are an electron emission apparatus and an electronic apparatus. The electron emission apparatus comprises a fire-resistant container and a heating power source, wherein an electron emission material is provided in a cavity part; and an electron extraction electrode plate is provided beneath the fire-resistant container. The embodiments of the present disclosure have a relatively high field emission effect of electrons, and high consistency of electron-beam currents in different emission arrays; by using a liquid and a cavity to prepare a liquid needle tip, the selection range of an electron emission material can be expanded, and under the action of an electron extraction electric field, the structure of a liquid needle tip having a smaller radius is further drawn, thereby enhancing a field emission effect of the electrons, and greatly improving the efficiencies of an electron microscope and electron-beam exposure machine; and the service life of an electron emission structure is directly proportional to the mass of the accommodated electron emission material, such that the service life of electron generation can be significantly prolonged compared with the service life of traditional thermal-field emission and cold-field emission filaments, and the applications of an electron-beam exposure machine, a scanning electron microscope, a transmission electron microscope and other X-ray light sources can be satisfied.

## Description

### Technical field

The present disclosure relates to an electron emission source, and in particular, to an electron emission apparatus.

### Background

The electron emission apparatus is an important invention in modern times, and its applications in our daily life include a cathode ray tube display, a ray tube which generates an X-ray by bombarding a heavy metal with an electron beam generated by the cathode ray tube display after the electron beam is accelerated to a high voltage, etc. Although the cathode ray tube display has faded out of our daily life, the X-ray source excited by the electron emission apparatus is still widely used in medical equipment such as chest X-rays and CT for examination. A vacuum electron tube made from the electron emission apparatus still plays a very important role in high frequency and high power microwave technologies, such as radar. In scientific researches, a scanning electron microscope, a transmission electron microscope, a mass spectrometer, etc., are all inseparable from the electron emission apparatus, and an electron beam exposure machine, as photolithography mask manufacturing equipment in a modem chip production technology, is also inseparable from the electron emission apparatus.

Main physical mechanisms of the existing electron emission apparatus include photo excitation, thermal excitation, electric field excitation, and secondary electron generation, or combination thereof. Of these, an electron generation technology by photo excitation is mainly used in a photomultiplier tube; a scanning electron microscope and an electron beam exposure technology mainly adopt thermal excitation and electric field excitation technologies, especially thermal field emission technology and cold field emission technologies. The thermal field emission technology is widely used in the electron beam exposure machine, a high-end scanning electron microscope, and a transmission electron microscope because it can output a very stable and high electron beam current for a long time. A current thermal field emission electron beam apparatus is a thermal field electron emission filament. When emitting electrons, the filament material is solid, and a strong electric field required for field emission depends on processing accuracy of a filament tip. Usually, a tungsten single crystal is chemically etched to form a needle tip with a very high height-width ratio, and a radius of the tip is within 100 nm to ensure the strong electric field required for field emission. The disadvantages of such apparatus include: 1) repeatability of a geometry and a size of the needle tip processed by chemically etching the tungsten single crystal is poor, electron emission consistency of the processed filament is not high, and installation and commissioning are troublesome; 2) the filament has a large geometric size, and usually a diameter of the filament for an electron microscope is 1-2 cm after assembly, making such filaments difficult to be installed in the electron microscope or the electron beam exposure machine in the form of array; 3) lifetime of the filament is relatively short, generally around 10000 hours; 4) the electron beam current emitted by the filament is instable or ineffective etc. al due to defects, adsorption and the like in the tungsten needle tip after chemical etching; and 5) at present, a preparation technology of the needle tip is limited to a few materials such as W and LaB6, which limits a selection range of materials for the electron beam emission apparatus.

### Summary of the invention

In view of the above, the embodiments of the present disclosure provide an electron emission apparatus and an electronic apparatus to overcome the disadvantages of lacking of consistency of existing solid thermal emission or thermal field emission filament products, difficulty in using filaments to form a compact array, short service life, and the like.

The present disclosure provides an electron emission apparatus including a fire-resistant container having a cavity part with a certain degree of vacuum, and a heating power supply, where an electron emission material is provided in the cavity part, and a plurality of through holes are provided at the bottom of the fire-resistant container; after melting by being heated, the electron emission material passes through the through hole to form an arc-shaped outwards-convex liquid surface, and emits electrons outwards; an electron extraction electrode plate is provided beneath the fire-resistant container; the electron extraction electrode plate is provided with cavities for the electrons to pass; the through holes correspond to the cavities one to one; and an electron extraction electric field for accelerating the electrons is formed between the fire-resistant container and the electron extraction electrode plate.

In some embodiments, the electron emission apparatus further includes an extraction power supply, where a negative electrode of the extraction power supply is connected to the outwards-convex liquid surface of the electron emission material via an inner wall of the fire-resistant container, and a positive electrode of the extraction power supply is connected to the electron extraction electrode plate.

In some embodiments, a distance between the fire-resistant container and the electron extraction electrode plate ranges from 50 um to 5000 um.

In some embodiments, an axis of the cavity is collinear with that of the through hole corresponding thereto.

In some embodiments, a melting temperature of the fire-resistant container is higher than a melting temperature of the electron emission material and a working temperature of the electron emission apparatus, and the melting temperature of the electron emission material is lower than the working temperature of the electron emission apparatus.

In some embodiments, a cross section of the fire-resistant container is in the shape of at least one of a circle, a rectangle, an oblong, and an ellipse, and the cavity part is a circular cavity.

In some embodiments, the electron emission material is at least one of a semiconductor material, an electrically insulating material, and a metal material.

In some embodiments, the semiconductor material is GaAs or InP; or the electrically insulating material is at least one of CsO₂, Zr₂O₃, Y₂O₃, BeO, WO₃, Rb₂O, and Ir₂O₃; or the metal material is at least one of W, Re, Ru, Pt, and Zr.

In some embodiments, a plurality of the through holes are provided at the bottom of the fire-resistant container, so as to form an electron emission array.

In some embodiments, the electron emission apparatus further includes a heating apparatus provided on a side wall of the fire-resistant container for heating the fire-resistant container and the electron emission material therein.

The present disclosure further provides an electronic apparatus, where the electronic apparatus adopts the electron emission apparatus in any one of the above technical solutions, and the electronic apparatus at least includes one of a vacuum electron tube, an X-ray generator, an electronic display and a thermoelectric transducer.

The embodiments of the present disclosure can achieve a relatively high electron field emission effect, a high degree of consistency in product structure, easy commissioning, and high consistency of electron beam currents in different emission arrays. By using a liquid and a cavity to prepare a liquid needle tip, a selection range of the electron emission material can be expanded; and under an electron extraction electric field, a structure of the liquid needle tip with a smaller radius can be further drawn, so as to further enhance a local electric field, enhance a field emission effect of electrons, and greatly improve efficiency of an electron microscope and electron beam exposure machine. The service life of the electron emission structure is in direct proportion to a mass of the contained electron emission material, so that the electron emission service life can be significantly prolonged as compared with that of a traditional thermal field emission or cold field emission filament, thereby meeting the use requirements of the electron beam exposure machine, a scanning electron microscope, a transmission electron microscope, and other X-ray sources.

### Brief Description of the Drawings

In order to more clearly explain the embodiments of the present disclosure or the technical solutions in the prior art, the accompanying drawings needed in the description of the embodiments or the prior art will be briefly introduced beneath. Obviously, the accompanying drawings in the following description are only some of the embodiments recorded in the present disclosure, and other accompanying drawings can be obtained based on these accompanying drawings for those skilled in the art without creative work.
Fig. 1 is a schematic structural diagram of an electron emission apparatus according to an embodiment of the present disclosure;
Fig. 2 is a schematic principle diagram of an electron emission apparatus according to an embodiment of the present disclosure; and
Fig. 3 is a schematic diagram showing electron emission of an electron emission apparatus according to an embodiment of the present disclosure.

### Detailed Embodiments

In order to make the purposes, technical solutions and advantages of the embodiments of the present disclosure clearer, the technical solutions of the embodiments of the present disclosure will be clearly and completely described beneath with reference to the accompanying drawings of the embodiments of the present disclosure. Obviously, the described embodiments are some embodiments, rather than all embodiments, of the present disclosure. Based on the described embodiments of the present disclosure, all other embodiments obtained by those skilled in the art without creative work fall into protection scope of the present disclosure.

Unless otherwise defined, technical terms or scientific terms used in the present disclosure shall have their ordinary meanings as understood by people with ordinary skills in the art to which the present disclosure belongs. The terms "first", "second" and the like used in the present disclosure do not indicate any order, quantity or importance, but are only used to distinguish different components. Similar words such as "comprise" or "contain" mean that the elements or objects appearing before the word cover the listed elements or objects appearing after the word and their equivalents, without excluding other elements or objects. Similar words such as "connection" or "connected" are not limited to physical or mechanical connection, and may include electrical connection, whether directly or indirectly. "Up", "down", "left", and "right" are only used to indicate a relative positional relationship; and when an absolute position of the described object changes, the relative positional relationship may also change accordingly.

In order to keep the following description of the embodiments of the present disclosure clear and concise, the detailed description of known functions and known components is omitted from the present disclosure.

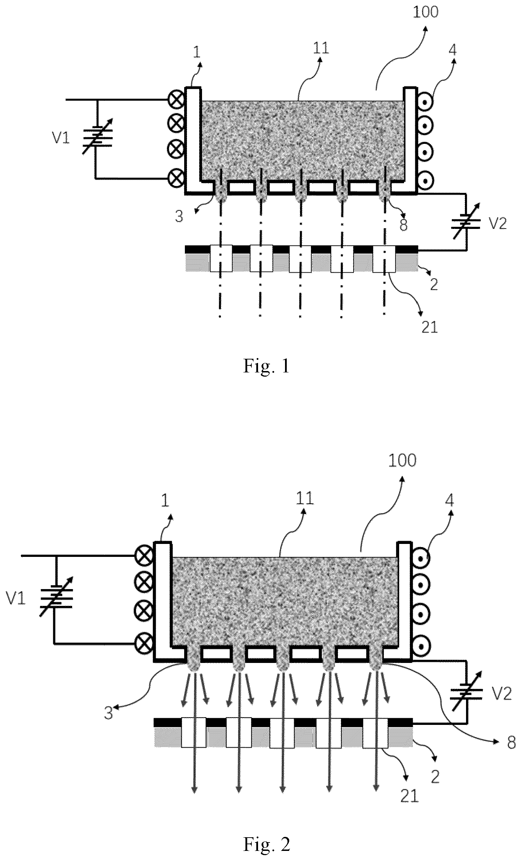

An embodiment of the present disclosure relates to an electron emission apparatus. The electron emission apparatus here is mainly applied to an electron microscope and an electron beam exposure technology, and may also be used in other devices such as vacuum electron tubes, X-ray generators, electronic displays, and thermoelectric transducers. As shown in Figs. 1 to 3, an embodiment of the present disclosure relates to an electron emission apparatus 100, which may be provided at the top of a scanning electron microscope/electron beam lithography column of a device such as a scanning electron microscope, a transmission electron microscope, and an electron beam exposure machine, for example. Specifically, the electron emission apparatus 100 includes a fire-resistant container 1, a cross section of which may be in the shape of a circle, and may also be in other shapes of a rectangle, an oblong and an ellipse, for example; the fire-resistant container 1 has a cavity part 11 which is a vacuum cavity with a certain degree of vacuum; and the cavity part 11 here may be a circular cavity with an inner diameter ranging from 1 um to 100 um. An electron emission material having a fixed melting temperature is provided in the cavity part 11 of the fire-resistant container 1.

Further, the fire-resistant container 1 here is made of a material with a relatively high melting temperature, such as a metal material. The melting temperature of the material of the fire-resistant container 1 is higher than that of the electron emission material, and also higher than a working temperature of the electron emission apparatus 100; and the melting temperature of the electron emission material is lower than the working temperature of the electron emission apparatus 100. In this way, when the electron emitting device 100 works, the electron emission material will melt into a liquid state, while the fire-resistant container 1 will not melt. It should be noted that the electron emission material and the material of the fire-resistant container 1 will not produce a chemical reaction or form an alloy between a room temperature and the melting temperature of the fire-resistant container 1.

Further, the electron emission material here refers to a material that absorbs a certain amount of energy, so that electrons break free from bindings of atomic nucleus and are emitted out of atoms. The electron emission material here may be a semiconductor material, preferably a semiconductor material with a low work function, such as GaAs, InP or the like, an energy band gap of which is between 0.2 eV and 5 eV at the room temperature; in addition, the electron emission material may also be an electrically insulating material, preferably an oxide material with a low work function, such as CsO₂, Zr₂O₃, Y₂O₃, BeO, WO₃, Rb₂O, Ir₂O₃ or the like; certainly, the electron emission material may also be a metal material, preferably a metal material with a low work function, such as W, Re, Ru, Pt, Zr or the like.

Further, a plurality of through holes 3 are provided at a bottom of the fire-resistant container 1. After melting by being heated, the electron emission material passes through the through hole 3 to form an arc-shaped outwards-convex liquid surface, and emits electrons outwards. The through hole 3 here is a micron-sized through hole formed by means of a micro-nano processing technology, and a diameter of the through hole 3 is between 0.1 um and 100 um. The micro-nano processing technology allows for a high degree of structure consistency. A plurality of the through holes 3 are provided, so that formation of an electron emission array can be facilitated.

In order to construct an electric field to facilitate the outwards-convex liquid surface 8 to emit an electron beam, an electron extraction electrode plate 2 is provided beneath the fire-resistant container 1; the electron extraction electrode plate 2 is provided with cavities 21 for the electrons to pass; the through holes 3 correspond to the cavities 21 one to one; and an electron extraction electric field 22 for accelerating the electrons is formed between the fire-resistant container 1 and the electron extraction electrode plate 2. After melting, the electron emission material flows to the outside of the through hole 3 through a through hole array beneath the fire-resistant container 1 due to the gravity or capillary force, and then forms an arc-shaped outwards-convex surface outside each through hole 3 due to immersional wetting of a side wall of the through hole 3. Under an electron extraction electric field 22, each outwards-convex surface can further draw a structure of a liquid needle tip with a smaller radius, so as to further enhance a local electric field and enhance a field emission effect of the electrons. Each liquid needle serves as an electron emission source to form an electron emission array, which may emit a very large beam current. Scanning and switching-on/off can be achieved after the electron source emitted by each liquid needle is focused, which can be used in a multi-beam scanning electron microscope and a multi-beam electron beam exposure apparatus, greatly improving efficiency of the electron microscope and the electron beam exposure machine.

A cross section of the cavity 21 is in the shape of a circle, and the cavity 21 has a diameter ranging from 1 um to 120 um.

Specifically, the electron emission apparatus further includes an extraction power supply 7 which may be provided outside the fire-resistant container 1, where a negative electrode of the extraction power supply 7 is connected to the outwards-convex liquid surface of the electron emission material via an inner wall of the fire-resistant container 1, and a positive electrode of the extraction power supply 7 is connected to the electron extraction electrode plate 2. The extraction power supply 7 is an adjustable DC voltage source with an output voltage between 0 V and 6kV. The electron extraction electric field 22 is established between the fire-resistant container 1 and the electron extraction electrode plate 2 using the extraction power supply 7.

In some embodiments, a distance between the fire-resistant container 1 and the electron extraction electrode plate 2 ranges from 50 um to 5000 um.

In some embodiments, an axis of the cavity 21 is collinear with that of the through hole 3 corresponding thereto. More specifically, the axis of the cavity 21 coincides with a symmetry axis of the corresponding arc-shaped outwards-convex liquid surface. After formation of a liquid needle, a tip of the liquid needle can reliably point to a middle part of the cavity 21, thereby ensuring reliable electron emission.

In addition, the electron emission apparatus 100 further includes a heating device 4 and a heating power supply 6, where the heating device 4 is provided on a side wall of the fire-resistant container 1 for heating the fire-resistant container 1 and the electron emission material therein, and may be a device such as a resistance wire; the heating power supply 6 is connected to the heating device 4 to supply electric energy to heat the electron emission material in the fire-resistant container 1 to its melting temperature or above by means of the heating device 4, is provided outside the fire-resistant container 1, and adjusts the electric energy supplied to the heating device 4 by adjusting a power, where the heating power supply 6 is a constant-voltage DC power source with an output current between 0 A and 10 A.

In some embodiments, in a case where the fire-resistant container 1 is made of a conductive material, such as a metal material, the heating device 4 may not be provided, and the heating power supply 6 may be directly connected to an outer wall of the fire-resistant container 1, so that the electron emission material in the fire-resistant container 1 can be heated to its melting temperature or above by adjusting the power.

As mentioned above, after the electron emission material is heated to its melting temperature or above, the electron emission material will be in a liquid state after melting, and the liquid electron emission material will pass through the through hole 3 due to the gravity and the like, forming the arc-shaped outwards-convex liquid surface 8. Specifically, since the working temperature of the electron emission apparatus 100 is higher than melting temperature of the electron emission material, there will be immersional wetting between the liquid and a solid between the melting temperature of the electron emission material and the working temperature of the electron emission apparatus 100, that is, the electron emission material in the liquid state, after passing through the through hole 3 due to the gravity and the like, will form the arc-shaped outwards-convex liquid surface 8 at an opening of the through hole 3.

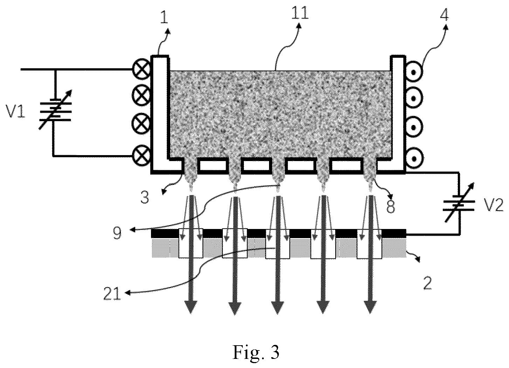

In this way, after the electron emission material reaches the melting temperature, that is, melts by being heated, due to immersional wetting between the solid of the side wall of the through hole 3 and the liquid, the electron emission material in the liquid state, based on immersional wetting of the side wall of the through hole 3, passes through the through hole 3 of the fire-resistant container 1 due to the gravity or capillary force, forming the arc-shaped outwards-convex liquid surface 8, which may emit an electron beam under a strong electric field, at the opening of the through hole 3. Further, as shown in Fig. 3, under a high electric field, the outwards-convex liquid surface 8 may further draw a droplet structure with a smaller radius, that is, form the structure of the liquid needle tip 9, so as to further enhance the local electric field and enhance the field emission effect of the electrons. Each liquid needle in the electron emission array emits electrons with high brightness, and the liquid needle array emits an electron source array with high brightness, thereby achieving an electron emission source array with high brightness.

In the embodiments of the present disclosure, the outwards-convex liquid surface 8 can be formed by cooperation of the liquid obtained from the melted electron emission material and the through hole 3, and the outwards-convex liquid surface 8 forms the liquid needle tip 9 under a strong DC electric field, so that the selection range of the electron emission material can be expanded. The structural service life of such electron emission apparatus 100 is in direct proportion to the mass of the contained electron emission material, and thus, the electron emission service life of the electron emission apparatus 100 can be significantly prolonged as compared with that of a traditional thermal field emission filament or cold field emission filament.

The process of adopting the electron emission apparatus 100 according to the embodiments of the present disclosure, as shown in Figs. 1 to 3, can be implemented in the following ways: in the cases of the scanning electron microscope, the transmission electron microscope or the electron beam exposure machine, the fire-resistant container 1 in the electron emission apparatus 100 is provided at the top of the scanning electron microscope/electron beam lithography column therein, the electron emission material in the above embodiments is further provided in the cavity part 11 of the fire-resistant container 1, the heating power supply 6 is connected to the heating device 4, and the heating device 4 is connected to the fire-resistant container 1. In a case where the fire-resistant container 1 is made of the metal material, the heating power supply 6 may be directly connected to the fire-resistant container 1.

Further, after the cavity part 11 of the fire-resistant container 1 located at the top of the scanning electron microscope/electron beam lithography column, for example, is evacuated to a high vacuum state, for example, after the degree of vacuum in the cavity part 11 is adjusted to 1 micro Pascal, the power V1 of the heating power supply 6 is adjusted until the temperature of the electron emission material reaches the melting temperature, so that the electron emission material begins to melt; then, the power V1 of the heating power supply 6 is gradually increased, until the electron emission material melting into liquid state in the fire-resistant container 1 passes through the through hole 3 at a lower end of the fire-resistant container 1 and continuously falls due to the gravity or capillary force, so that a stable arc-shaped outwards-convex liquid surface 8 is formed at a lower opening of the through hole 3 due to the joint action of immersional wetting between the electron emission material in the liquid state and the through hole 3 in a solid state as well as liquid surface energy; and then, a voltage of the extraction power supply 7 is gradually increased, so that a strong electric field is formed under the extraction power supply 7, and the outwards-convex liquid surface 8 emits an electron beam under the strong electric field, thereby achieving a purpose of emitting the electrons. Certainly, the outwards-convex liquid surface 8 can also form a stable liquid needle tip 9 under the strong electric field and the liquid surface energy, and the liquid needle tip 9 can further enhance the local electric field intensity, thereby enhancing the field emission effect of emitting the electron beams and achieving the purpose of forming the electron emission apparatus having high brightness. In this case, an array of liquid needle tips 9 is formed outside the array of the through holes 3, each liquid needle tip 9 in the array emits electrons with high brightness, and the array of liquid needle tips 9 emits an electron source array with high brightness, thereby achieving an electron emission source array with high brigntness.

In the process of emitting the electron beam by means of the electron emission apparatus, the capillary action of the liquid, a structure of a micron-sized capillary tube, immersional wetting of the materials, the electric field effect and the like are adopted, so that the electron field emission effect is relatively high, the degree of structural consistency is relatively high, and commissioning is easy; and the structural service life of the electron emission apparatus is in direct proportion to the mass of the contained electron emission material, so that the electron emission service life can be significantly prolonged as compared with that of the traditional thermal field emission filament or cold field emission filament.

An embodiment of the present disclosure further provides an electronic apparatus, where the electronic apparatus adopts the electron emission apparatus in any one of the above technical solutions, and the electronic apparatus here at least includes one of a vacuum electron tube, an X-ray generator, an electronic display, and a thermoelectric transducer.

The above description is only the explanation of the preferred embodiments of the present disclosure and the applied technical principles. It should be understood by those skilled in the art that the disclosure scope involved in the present disclosure is not limited to the technical solution formed by the specific combination of the above technical features, but also covers other technical solutions formed by any combination of the above technical features or their equivalent features without departing from the above disclosure concept, for example, technical solutions formed by mutual substitution of the above features and technical features with similar functions disclosed, but not limited to, in the present disclosure.

In addition, although operations are depicted in a particular order, this should not be understood as requiring that such operations be performed in the particular order shown or in a sequential order. In certain circumstances, multitasking and parallel processing may be advantageous. Likewise, although several specific implementation details are contained in the above discussion, these should not be construed as limitations on the scope of the present disclosure. Certain features that are described in the context of separate embodiments may also be implemented in combination in a single embodiment. Conversely, various features that are described in the context of a single embodiment may also be implemented in multiple embodiments separately or in any suitable sub-combination.

Although the subject matter has been described in languages specific to structural features and/or methodological acts, it is to be understood that the subject matter defined in the appended claims is not necessarily limited to the specific features or acts described above. On the contrary, the specific features and actions described above are merely exemplary forms for implementing the claims.

Although a plurality of embodiments of the present disclosure have been described in detail above, the present disclosure is not limited to these specific embodiments. Those skilled in the art can make various variations and modifications to the embodiments based on the concepts of the present disclosure. These variations and modifications all should fall within the protection scope claimed by the present disclosure.

## Claims

1. An electron emission apparatus, comprising a fire-resistant container having a cavity part with a certain degree of vacuum, and a heating power supply, wherein an electron emission material is provided in the cavity part; a plurality of through holes are provided at the bottom of the fire-resistant container; after melting by being heated, the electron emission material passes through the through hole, forming an arc-shaped outwards-convex liquid surface, and emits electrons outwards; an electron extraction electrode plate is provided beneath the fire-resistant container; the electron extraction electrode plate is provided with cavities for the electrons to pass; the through holes correspond to the cavities one to one; and an electron extraction electric field for accelerating the electrons is formed between the fire-resistant container and the electron extraction electrode plate.

2. The electron emission apparatus according to claim 1, further comprising an extraction power supply, wherein a negative electrode of the extraction power supply is connected to the outwards-convex liquid surface of the electron emission material via an inner wall of the fire-resistant container, and a positive electrode of the extraction power supply is connected to the electron extraction electrode plate.

3. The electron emission apparatus according to claim 1, wherein a distance between the fire-resistant container and the electron extraction electrode plate ranges from 50 um to 5000 um.

4. The electron emission apparatus according to claim 1, wherein an axis of the cavity is collinear with that of the through hole corresponding thereto.

5. The electron emission apparatus according to claim 1, wherein a melting temperature of the fire-resistant container is higher than a melting temperature of the electron emission material and a working temperature of the electron emission apparatus, and the melting temperature of the electron emission material is lower than the working temperature of the electron emission apparatus.

6. The electron emission apparatus according to claim 1, wherein a cross section of the fire-resistant container is in the shape of at least one of a circle, a rectangle, an oblong, and an ellipse, and the cavity part is a circular cavity.

7. The electron emission apparatus according to claim 1, wherein the electron emission material is at least one of a semiconductor material, an electrically insulating material, and a metal material.

8. The electron emission apparatus according to claim 7, wherein the semiconductor material is GaAs or InP; or the electrically insulating material is at least one of CsO₂, Zr₂O₃, Y₂O₃, BeO, WO₃, Rb₂O, and Ir₂O₃; or the metal material is at least one of W, Re, Ru, Pt, and Zr.

9. The electron emission apparatus according to claim 1, further comprising a heating device provided on a side wall of the fire-resistant container for heating the fire-resistant container and the electron emission material therein.

10. An electronic apparatus, wherein the electronic apparatus adopts the electron emission apparatus according to any one of the above claims, and the electronic apparatus at least comprises one of a vacuum electron tube, an X-ray generator, an electronic display, and a thermoelectric transducer.
